# EUROPÄISCHE PATENTSCHRIFT

(11) **EP 0 751 570 B1**
(45) Veröffentlichungstag und Bekanntmachung des Hinweises auf die Patenterteilung: **13.08.2003**
(21) Anmeldenummer: 96110238.1
(22) Anmeldetag: 25.06.1996
(51) Int. Cl.: H01L 25/16

(54) **Elektronisches kombiniertes Logik-Leistungsmodul**
Combined electronic logic power module
Module électronique combiné de puissance à circuit logique

(30) Priorität: 26.06.1995 DE 29510335 U
(43) Veröffentlichungstag der Anmeldung: 02.01.1997
(73) Patentinhaber: TYCO Electronics Logistics AG, 9323 Steinach (CH)
(72) Erfinder: Kaindl, Michael, 81739 München (DE)
(74) Vertreter: Klunker . Schmitt-Nilson . Hirsch

(56) Entgegenhaltungen:
- DE-A- 4 238 417
- US-A- 5 159 532
- PATENT ABSTRACTS OF JAPAN vol. 017, no. 518 (E-1434), 17. September 1993 & JP 05 136333 A (SANSHA ELECTRIC MFG CO LTD), 1. Juni 1993
- PATENT ABSTRACTS OF JAPAN vol. 005, no. 133 (E-071), 25. August 1981 & JP 56 069858 A (TOHOKU METAL IND LTD), 11. Juni 1981
- PATENT ABSTRACTS OF JAPAN vol. 016, no. 478 (E-1274), 5. Oktober 1992 & JP 04 171754 A (MITSUBISHI ELECTRIC CORP), 18. Juni 1992

## Beschreibung

Die Erfindung betrifft ein kombiniertes elektronisches Logik-Leistungsmodul, gemäß Oberbegriff des Anspruchs 1.

IPM (Intelligent Power Moduls)-Bauformen werden gegenwärtig hauptsächlich bei Anwendungen im Zusammenhang mit Schweißgeräten, Stromversorgungen und in der Antriebstechnik eingesetzt. Insbesondere im Bereich der Motorantriebe werden zunehmend Frequenzumrichterlösungen anstelle der traditionellen Gleichstromantriebe eingesetzt, wobei im Leistungsteil des Moduls IGBT (Isolated Gate Bipolar Transistor)-Leistungshalbleiter Verwendung finden.

Derzeit werden Logik- und Leistungsmodul vorwiegend als völlig selbständige Teile aufgebaut, wobei die Leistungsmodule meist auf DCB-Al₂O₃-Substrat (Direct Copper Bonding), auf DCB-AIN-Substrat oder auf IMS-Substrat (Aluminium Polyimid-Kupfer) gefertigt werden. Die Logikmodule werden auf Epoxy-Leiterplatten oder in Dickschicht-Techniken hergestellt. Auf dem Markt sind ferner einzelne kombinierte Logik-Leistungsmodule in Sandwich-Bauweise erhältlich. Dabei werden das mit den Leistungsbauteilen bestückte IMS-Substrat und die mit den Logikbauteilen bestückte Epoxy-Leiterplatte übereinander angeordnet und durch eine Vergußmasse thermisch gekoppelt.

Diese herkömmliche Modultechnik ist in mehrfacher Hinsicht noch nicht zufriedenstellend:

Grundsätzlich ist eine räumlich enge elektrische Kopplung zwischen dem Logik- und dem Leistungsteil erwünscht. Mit länger werdenden elektrischen Verbindungswegen wächst ansonsten die Gefahr, daß das korrekte Schaltverhalten durch induktives Einkoppeln externer Störquellen und durch die unterschiedlichen Massepotentiale der beiden Schaltungsteile beeinträchtigt wird. Die Verwendung getrennter Substrate für die beiden Schaltungsteile ist von daher grundsätzlich ungünstig. Andererseits steigt mit zunehmender räumlicher Nähe der beiden Schaltungsteile die Notwendigkeit einer Wärmeentkopplung des Logikteils von dem Leistungsteil, da der Logikteil durch den Leistungsteil nicht unzulässig erwärmt werden darf. Diese Probleme müssen im übrigen im Zusammenhang mit weiteren technischen Anforderungen wie einer ausreichenden Wärmeentsorgung des Leistungsteils zum Kühlkörper hin und einer zuverlässigen Anschlußtechnik für Logiksignale und Lastanschlüsse betrachtet und dabei auch in geometrisch günstiger Weise gelöst werden.

In Übereinstimmung mit dem Oberbegriff des Anspruchs 1 zeigt die US-A-5 159 532 ein kombiniertes Logik- und Leistungsmodul, bei dem die in getrennten Bereichen angeordneten Module auf einem eine durchgehend gleiche Dicke aufweisenden Kühlkörper angebracht sind, der sich nicht nur unterhalb des Leistungsmoduls und des Logikmoduls erstreckt, sondern sich noch über deren Ränder hinaus. Die Verbindung zu einer externen Schaltung erfolgt über einen Anschlußstecker.

Aus PATENT ABSTRACTS OF JAPAN Vol. 005, 0133 (E-071), 25. August 1981 & JP 56 069858 A ist es bekannt, in einem Hybrid-IC einen Leistungstransistor mit besonderer Wärmeleitung an einer Stelle unterzubringen, an der das Substrat für die übrigen, wenig Leistung freisetzenden Bauelemente ein Durchgangsloch aufweist, in welchem sich ein Metallpfropfen als Wärmeableiter befindet, welcher seinerseits mit eine Kühlplatte in Verbindung steht, die sich auf der Unterseite des gesamten Schaltungssubstrats erstreckt.

Der Erfindung liegt die Aufgabe zugrunde, ein elektronisches kombiniertes Logik-Leistungsmodul der eingangs angegebenen Art hinsichtlich der beschriebenen Problematik zu verbessern.

Erfindungsgemäß wird dies bei einem Modul der eingangs genannten Art erreicht durch die Merkmale des Anspruchs 1.

Vorteilhafte Ausgestaltungen ergeben sich aus den abhängigen Ansprüchen.

Weitere vorteilhafte Ausgestaltungen und Weiterbildungen der Erfindung sind Gegenstand der Unteransprüche.

Die Erfindung soll nun anhand zweier Ausführungsbeispiele unter Bezugnahme auf die beigefügte Zeichnung näher erläutert werden. Es zeigen:
Figur 1 in einer perspektivischen Aufsicht ein erstes Ausführungsbeispiel mit Kühlrippen
Figur 2 in der gleichen Darstellungsweise wie Figur 1 ein zweites Ausführungsbeispiel mit einer Kühlplatte.

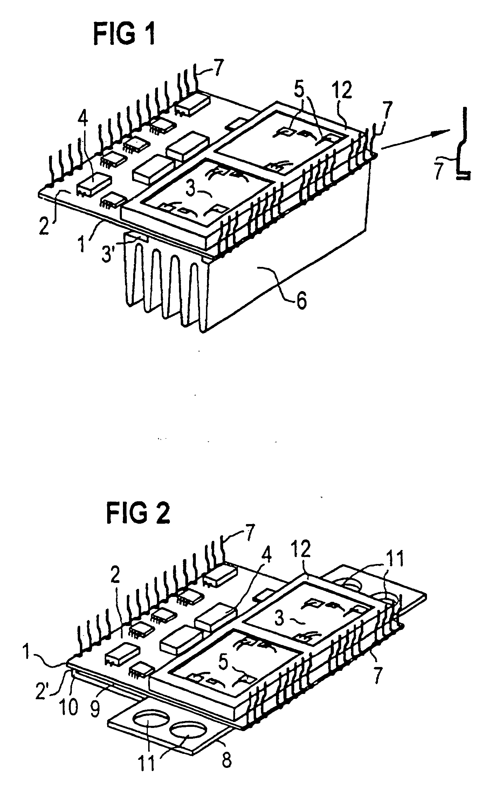

In Figur 1 ist ein beispielsweise zum Schalten bzw. stufenlosen Regeln im Leistungsbereich von 5 A und 600 V geeignetes kombiniertes Modul dargestellt, wobei einer der Anschlußpins 7 zusätzlich gesondert und vergrößert im rechten oberen Teil der Figur 1 dargestellt ist. Das gemeinsame Dickschichtsubstrat 1 ist erkennbar in einen ersten, den Logikbauteilen 4 vorbehaltenen Bereich 2 und in einen zweiten, den Leistungsbauteilen 5 vorbehaltenen Bereich 3 räumlich aufgeteilt und getrennt. Bei der dargestellten Ausführungsform wird die Begrenzung der wärmeableitenden Wirkung auf den Bereich 3' unterhalb des Leistungsteils (der Bereich 3' korrespondiert mit dem Bereich 3 der Oberseite) einfach dadurch gewährleistet, daß nur dort ein mit Rippen versehener Kühlkörper 6 angeordnet ist. Durch eine spezielle Pinausformung, bei der die Anschlußpins 7 senkrecht zum Dickschichtsubstrat 1 angeordnet und in Steckrichtung elastisch ausgebildet sind, wird eine flexible Anschlußtechnik für Leistungs- und Logikteil realisiert. Durch die wellenartige Ausformung der mittleren Bereiche der Anschlußpins 7 sind diese zieh- bzw. stauchbar, so daß in Steckrichtung auftretende unzulässig hohe mechanische Spannungen im eingebauten Zustand vermieden werden.

In Figur 2 ist ein auf der Unterseite des Dickschichtsubstrats 1 angeordneter, mit diesem im wesentlichen kongruenter Kühlkörper dargestellt, der als Kühlplatte 8 ausgebildet ist, die im Bereich 2' unterhalb des Logikteils mit einem Luftspalt 9 versehen ist. Dadurch ist einerseits auch der Logikteil mittels der Auflageleiste 10 abgestützt, so daß eine gute mechanische Stabilität gegeben ist. Andererseits wird durch den Luftspalt 9 zwischen der Kühlplatte 8 und dem Logikteil eine thermische Entkopplung von Leistungs- und Logikteil bewirkt. Diese Entkopplung beruht bei allen Ausführungsformen auch wesentlich darauf, daß aufgrund der schlecht wärmeleitenden Dickschichtkeramik eine direkte Wärmeleitung in horizontaler Richtung vom Leistungsteil zum Logikteil vernachlässigbar ist. In Figur 2 ist außerdem erkennbar, daß die Kühlplatte 8 mit Montagelöchern 11 versehen ist, mittels derer eine spätere Montage des Moduls auf einen größeren Kühlkörper in einem Komplettsystem, beispielsweise einem Inverter, möglich ist.

Das Dickschichtsubstrat wird vorteilhaft mit sehr niederohmigen AgPt-Leiterbahnen versehen, die einerseits für eine hohe Stromtragfähigkeit sorgen und andererseits löt- und bondbar sind. Auf dem Dickschichtsubstrat werden ungehäuste Leistungshalbleiter, beispielsweise IGBT oder FRED (Fast Recovery Diode) angeordnet, die zur Erzielung eines geringen Wärmewiderstandes vorzugsweise gelötet werden. Die elektrische Verbindung kann mittels Aluminium-Dickdraht erfolgen. Durch einen Silicongelverguß, der in den Figuren im Rahmen 12 schematisch angedeutet ist, wird der Leistungsteil vor Umwelteinflüssen und Spannungsüberschlägen bei Betriebsspannungen bis 1200V geschützt.

Es ist vorteilhaft, Shunt-Widerstände, die als Sensoren für Überwachungsfunktionen dienen, integriert auf der Schaltung unterzubringen. Auf dem Modul kann durch aktives Lasertrimmen die gesamte Schaltung abgeglichen werden, indem beispielsweise eine präzise Strom-Spannungs-Korrelation erzeugt wird. Die erforderlichen Luft- und Kriechstrecken können bei der Layout-Topographie und bei der Kühlkörper- und Pinmontage ohne weiteres berücksichtigt werden.

Zur Wärmeentsorgung des Leistungsteils wird der Kühlkörper bzw. die Kühlplatte beispielsweise mittels Klebetechnik auf das Substrat aufgebracht. Diese Montagetechnik gleicht durch einen flexiblen und gut wärmeleitenden Kleber unterschiedliche Längenausdehnungskoeffizienten aus und sorgt für einen geringen Wärmewiderstand zwischen der Sperrschicht und dem Kühlkörper. Zur Verbesserung des Wärmeübergangs ist es vorteilhaft, die Klebeschicht nur bereichsweise an unterhalb der jeweiligen Verlustleister befindlichen Stellen vorzusehen. Auch eine Löttechnik beispielsweise mit CuInCu-Kühlkörper bzw. -platte (ähnlicher Ausdehnungskoeffizient wie Keramik) ist möglich.

## Patentansprüche

1. Elektronisches kombiniertes Logik-Leistungsmodul, bei dem Logik- und Leistungsbauelemente (4, 5) jeweils auf einem Schaltungsträger aufgebaut und mit Anschlüssen versehen sind und bei dem das kombinierte Modul mit einem Kühlkörper versehen ist, wobei
die Logik- und Leistungsbauelemente (4,5) jeweils in getrennten Bereichen (2,3) auf einer Hauptfläche eines gemeinsamen Dickschichtsubstrats (1) hybridiert aufgebaut sind,
**dadurch gekennzeichnet ,**
**daß** der Logikteil durch einen auf der gegenüberliegenden Hauptfläche des Dickschichtsubstrats (1) wärmeleitend befestigten und nur im Bereich (3') unterhalb des Leistungsteils wärmeableitend wirksamen Kühlkörper (6,8) thermisch vom Leistungsteil entkoppelt ist,
und **daß** das kombinierte Modul mit einheitlichen Anschlußpins (7) für Logiksignale und Lastanschlüsse versehen ist.

2. Kombiniertes Modul nach Anspruch 1,
**dadurch gekennzeichnet,**
**daß** ein nur im Bereich (3')unterhalb des Leistungsteils angeordneter, mit Kühlrippen versehener Kühlkörper (6) vorgesehen ist.

3. Kombiniertes Modul nach Anspruch 1,
**dadurch gekennzeichnet,**
**daß** der Kühlkörper als mit dem Dickschichtsubstrat (1) kongruente Kühlplatte (8) ausgebildet ist, die im Bereich (2') unterhalb des Logikteils mit einem Luftspalt (9) versehen ist.

4. Kombiniertes Modul nach Anspruch 3,
**dadurch gekennzeichnet,**
**daß** die Kühlplatte (8) so ausgebildet ist, daß das Modul durch Montage an einem größeren Kühlelement innerhalb einer Geräteanordnung integrierbar ist.

5. Kombiniertes Modul nach einem der Ansprüche 1 bis 4,
**dadurch gekennzeichnet,**
**daß** die Anschlußpins (7) senkrecht zum Dickschichtsubstrat (1) angeordnet und in Steckrichtung elastisch ausgebildet sind.

6. Kombiniertes Modul nach einem der Ansprüche 1 bis 5,
**dadurch gekennzeichnet,**
**daß** das Dickschichtsubstrat (1) mit niederohmigen AgPt-Leiterbahnen versehen ist.

7. Kombiniertes Modul nach einem der Ansprüche 1 bis 6,
**dadurch gekennzeichnet,**
**daß** auf dem Dickschichtsubstrat (1) ungehäuste Leistungshalbleiter (5), insbesondere vom IGBT- oder FRED-Typ, aufgelötet und mittels Aluminium-Dickdraht mit den Leiterbahnen des Substrats (1) verbunden sind.

8. Kombiniertes Modul nach Anspruch 7,
**dadurch gekennzeichnet,**
**daß** das Leistungsteil mit einem Silicongelverguß (12) versehen ist.

## Claims

1. A combined electronic logic and power module, in which logic and power components (4, 5) are each constructed on a circuit carrier and are provided with terminals and in which the combined module is provided with a heat sink, the logic and power components (4, 5) each being constructed in hybrid manner in separate areas (2, 3) on a main face of a common thick-film substrate (1),
**characterised in that** the logic part is thermally decoupled from the power part by a heat sink (6, 8) attached in heat-conducting manner on the opposing main face of the thick-film substrate (1) and having heat-dissipating action only in the area (3') below the power part,
and **in that** the combined module is provided with uniform terminal pins (7) for logic signals and load terminals.

2. A combined module according to claim 1,
**characterised in that**
a heat sink (6) is provided which is arranged only in the area (3') below the power part and provided with cooling fins.

3. A combined module according to claim 1,
**characterised in that**
the heat sink takes the form of a cooling plate (8) congruent with the thick-film substrate (1), which cooling plate is provided in the area (2') below the logic part with an air gap (9).

4. A combined module according to claim 3,
**characterised in that**
the cooling plate (8) is so constructed that the module may be integrated by mounting on a larger cooling element within a device arrangement.

5. A combined module according to one of claims 1 to 4,
**characterised in that**
the terminal pins (7) are arranged perpendicularly to the thick-film substrate (1) and are of resilient construction in the insertion direction.

6. A combined module according to one of claims 1 to 5,
**characterised in that**
the thick-film substrate (1) is provided with low-resistance AgPt conductive tracks.

7. A combined module according to one of claims 1 to 6,
**characterised in that**
bare power semiconductors (5), in particular of the IGBT or FRED type, are soldered to the thick-film substrate (1) and are connected to the conductive tracks of the substrate (1) by means of aluminium thick wire.

8. A combined module according to claim 7,
**characterised in that**
the power part is encapsulated in silicone gel (12).

## Revendications

1. Module de puissance et logique électronique combiné, dans lequel les composants logiques et les composants de puissance (4, 5) sont respectivement montés sur un support de circuit et comportent des raccordements, le module combiné comportant un corps de refroidissement, les composants logiques et de puissance (4, 5) étant respectivement montés de manière hybridée dans des secteurs séparés (2, 3) sur une surface principale d'un substrat à couche épaisse commun (1),
**caractérisé en ce que** le découplage thermique de la partie logique par rapport à la partie de puissance est assuré par un corps de refroidissement (6, 8), fixé par conduction thermique sur la surface principale opposée du substrat à couche épaisse (1) et assurant une dissipation de la chaleur uniquement dans la région (3') agencée au-dessous de la partie de puissance,
le module combiné comportant des broches de raccordement communes (7) pour les signaux logiques et les bornes de charge.

2. Module combiné selon la revendication 1,
**caractérisé en ce que**
un corps de refroidissement (6) comportant des ailettes de refroidissement est agencé uniquement dans la région (3') agence au-dessous de la partie de puissance.

3. Module combiné selon la revendication 1,
**caractérisé en ce que**
le corps de refroidissement a la forme d'une plaque de refroidissement (8) coïncidant avec le substrat à couche épaisse (1) comportant un intervalle d'air (9) dans la région (2') au-dessous de la partie logique.

4. Module combiné selon la revendication 3,
**caractérisé en ce que**
la plaque de refroidissement (8) est conçue de sorte que le montage sur un élément de refroidissement plus grand permet d'intégrer le module à l'intérieur d'un dispositif.

5. Module combiné selon l'une des revendications 1 à 4,
**caractérisé en ce que**
les broches de raccordement (7) sont agencées perpendiculairement au substrat à couche épaisse (1) et ont une structure élastique dans la direction d'insertion.

6. Module combiné selon l'une des revendications 1 à 5,
**caractérisé en ce que**
le substrat à couche épaisse (1) comporte des pistes conductrices de AgPt de basse impédance.

7. Module combiné selon l'une des revendications 1 à 6,
**caractérisé en ce que**
des semi-conducteurs de puissance sans boîtier (5), en particulier su type IGBT ou FRED, sont brasés sur le substrat à couche épaisse (1) et raccordés par l'intermédiaire de fil épais d'aluminium avec les pistes conductrices du substrat (1).

8. Module combiné selon la revendication 7,
**caractérisé en ce que**
la partie de puissance comporte un scellement au gel de silicone (12).
